# EUROPÄISCHE PATENTSCHRIFT

(11) **EP 1 549 464 B1**
(45) Veröffentlichungstag und Bekanntmachung des Hinweises auf die Patenterteilung: **13.12.2006**
(21) Anmeldenummer: 03779799.0
(22) Anmeldetag: 01.10.2003
(51) Int. Cl.: B24B 37/04, B24B 41/06

(54) **HALTERING ZUM HALTEN VON HALBLEITERWAFERN IN EINER CHEMISCH-MECHANISCHEN POLIERVORRICHTUNG**
RETAINING RING FOR HOLDING SEMICONDUCTOR WAFERS IN A CHEMICAL-MECHANICAL POLISHING DEVICE
ANNEAU DE FIXATION DE PLAQUETTES EN SEMICONDUCTEURS DANS UN DISPOSITIF DE POLISSAGE PAR VOIE CHIMIQUE-MECANIQUE

(30) Priorität: 02.10.2002 DE 10247180
(43) Veröffentlichungstag der Anmeldung: 06.07.2005
(73) Patentinhaber: Ensinger Kunststofftechnologie GbR, 71154 Nufringen (DE)
(72) Erfinder: ENSINGER, Wilfried, 71154 Nufringen (DE)
(74) Vertreter: Wössner, Gottfried
(86) Internationale Anmeldenummer: PCT/EP2003/010868
(87) Internationale Veröffentlichungsnummer: WO 2004/033153

(56) Entgegenhaltungen:
- EP-A- 1 065 030
- US-A- 5 695 392
- US-A- 6 030 280
- US-B1- 6 251 215
- US-B1- 6 277 008
- US-B1- 6 439 984

## Beschreibung

Die Erfindung betrifft einen Haltering zum Halten von Halbleiterwafern in einer chemisch-mechanischen Poliervorrichtung nach dem Oberbegriff des Anspruchs 1.

Heutzutage werden integrierte Schaltkreise typischerweise auf Halbleitersubstraten, insbesondere Siliziumwafern, hergestellt, wobei nacheinander leitende, halbleitende und isolierende Schichten auf dem Wafer abgeschieden werden. Nachdem jede Schicht abgelagert ist, wird geätzt, um die Schaltkreisfunktionen zu realisieren. Nachdem eine Reihe von Lagen sequenziell gelagert und geätzt wurde, wird die oberste Oberfläche des Halbleitersubstrates, d.h. die außenliegende Oberfläche des Substrates, mehr und mehr uneben. Diese unebene Oberfläche bereitet in photolitographischen Schritten beim Herstellungsprozess der integrierten Schaltkreise Probleme. Deshalb besteht die Notwendigkeit immer wieder, die Oberfläche des Malbfeitersubsfirates plan zu machen bzw. einzuebnen.

Hierfür stellt das sogenannte chemisch-mechanische Polieren (CMP) eine der anerkannten Methoden dar. Dieses Verfahren zur Erzielung der Planheit verlangt typischerweise, dass das Substrat, d.h. der Halbleiterwafer, auf einem Träger oder auch Polierkopf montiert wird. Die freiliegende Oberfläche des Substrates wird dann gegen eine rotierende Polierscheibe gedrückt. Über den Trägerkopf wird eine geregelte Kraft auf das Substrat ausgeübt, um dieses gegen die Polierscheibe zu drücken. Ein Poliermittel, welches mindestens ein chemisch reaktives Agens und abrasive Partikel enthält, wird auf die Oberfläche der Polierscheibe gegeben.

Ein immer wiederkehrendes Problem in dem CMP-Verfahren ist der sogenannte Randeffekt, d.h. die Tendenz, den Rand des Substrates, welches zu polieren ist, mit einer anderen Geschwindigkeit als die Mitte des Substrates zu polieren. Daraus resultiert typischerweise ein Zuviel an Polieren am Rand, d.h. hier wird zuviel Material vom Rand abgetragen, insbesondere bei den äußersten 5 bis 10 mm eines Wafers von 200 mm im Durchmesser.

Das Zuviel an Polieren reduziert die Ebenheit des Substrates über das Gesamte gesehen und macht den Rand des Substrates ungeeignet für die Herstellung von integrierten Schaltkreisen und verringert somit die Prozessausbeute.

Zur Lösung dieses Problemes schlägt die US-Patentschrift Nr. 6,251,215 vor, den Haltering zweiteilig zu gestalten, wobei ein Teil aus einem steifen Material hergestellt ist, nämlich einem Metallteil, und ein zweiter Teil aus einem Kunststoffmaterial, welches eine geringere Steifigkeit aufweist, so dass es zum Einen abrasiv belastbar ist und zum Anderen in Kontakt mit dem Halbleiterwafer dieses nicht beschädigen kann.

Auf Grund der Randbedingungen beim chemisch-mechanischen Polieren schlägt die US-Patentschrift Nr. 6,251,215 vor, den Kunststoffteil des Halteringes und den Metallring mit einem Epoxykleber miteinander zu verbinden. Alternativ wird vorgeschlagen, die beiden Teile im Presssitz miteinander zu verbinden.

In der Praxis erweisen sich beide Lösungen als unzureichend.

Während bei der Verbindung der beiden Teile miteinander mittels Epoxykleber das Kunststoffteil sicher an dem Metallteil gehalten wird, bereitet die Aufarbeitung des Halteringes nach einer gewissen Abrasion des Kunststoffteiles Probleme. In der derzeitigen Praxis müssen die kompletten Halteringe an den Hersteller eingeschickt werden, wo das Kunststoffteil mechanisch entfernt wird und nachfolgend die Klebereste von dem Metallteil durch Aufheizen auf ca. 200 °C thermisch zersetzt werden. Danach muss das Metallteil sandgestrahlt werden, um letzte Reste des Klebstoffes zu entfernen, und erst dann kann wieder ein neuer Kunststoffring aufgeklebt werden.

Auf Grund dieser zeit- und kostenintensiven Prozedur werden die Halteringe als solche sehr teuer. Hinzu kommt, dass die metallischen Halteelemente, die von den Produktionskosten her teurer sind als die Kunststoffelemente, nur eine geringe Zahl an Zyklen überstehen, insbesondere wegen der Temperaturbehandlung beim thermischen Abbau des Klebstoffes und der nachfolgend notwendigen Sandstrahlbehandlung.

Einfacher ist der Austausch eines verbrauchten Kunststoffringes bei der Verbindung von Metallteil und Kunststoffteil über einen Presssitz, jedoch stellt sich hier heraus, dass der Presssitz als Verbindung von Kunststoff- und Metallteil ungeeignet ist, um den beim Polierprozess auftretenden Kräften sicher zu widerstehen.

Aus dem US-Patent US 5,695,392 ist unter anderem ein einteiliger Haltering gemäß dem Oberbegriff des Anspruches 1 bekannt.

Aufgabe der vorliegenden Erfindung ist es, einen Haltering vorzuschlagen, der vorstehend genannte Probleme vermeidet.

Diese Aufgabe wird erfindungsgemäß durch den eingangs genannten Haltering gelöst, der die Merkmale des Kennzeichens des Anspruches 1 aufweist.

Die erfindungsgemäße Konstruktion des Halteringes erlaubt eine kostengünstige Fertigung, so dass nach einem übermäßigen Verschleiß der Haltering als Ganzes weggeworfen werden kann.

Um bei dem Haltering eine ausreichende Festigkeit zu realisieren, die sicherstellt, dass der Haltering in seiner Geometrie beim Poliervorgang nicht deformiert wird und dadurch zu einem unebenmäßigen Abtrag auf dem Halbleiterwafer führt, wird das Kunststoffmaterial entsprechend seinen mechanischen Eigenschaften ausgewählt.

Vorzugsweise ist der Haltering aus mindestens zwei Schichten oder Komponenten sandwichartig aufgebaut.

Das Kunststoffmaterial kann beispielsweise ein Thermoplast, ein Duroplast, ein Elastomer und/oder eine Kunststoffmischung umfassen.

Eine wesentlich größere Palette an Kunststoffmaterialen steht dann zur Verfügung, da man das Kunststoffmaterial in verstärkter, insbesondere in faserverstärkter Form einsetzt.

Hierbei ist vorgesehen, daß das Kunststoffmaterial benachbart zu seiner ersten Stirnseite, d.h. der Seite, die die Auflagefläche zur Auflage des Halteringes auf einer Polieroberfläche der Poliervorrichtung bildet, ohne Verstärkungsstoffe oder mit einem geringeren Gehalt an Verstärkungsstoffen versieht als an seiner die Montageelemente umfassenden Seite.

Dadurch erhält man in dem Bereich, der an der Poliervorrichtung gehalten wird, einen Teilbereich, der eine erhöhte mechanische Stabilität aufweist und der den Haltering in seiner Geometrie insgesamt stabilisiert. Auf der Seite, auf der der abrasive Verschleiß stattfindet, weist dann der Haltering geringere Festigkeiten auf und ist Insbesondere weniger hart, so dass ein Kontakt zwischen den zu bearbeitenden Halbleiterwafern und dem Kunststoffmaterial für die Wafer schonender ist.

Um den Verschleiß zu reduzieren bzw. die tribologischen Eigenschaften zu optimieren, können dem Kunststoffmaterial reib- und/oder verschleißmindernde Zusatzstoffe zugemischt werden, beispielsweise PTFE, Polyimid, Molybdändisulfid, Graphit, Bornitrid, Nanopartikel oder dergleichen.

Vorstellbar ist schließlich auch, dass sich die Verstärkungsstoffe auf einen Kernbereich des Halteringes beschränken, insbesondere den Bereich, in dem dann auch die Montageelemente angeordnet sind. Dies verleiht dem Haltering die notwendige Steifigkeit und geometrische Integrität auch bei einseitigen Belastungen, während ein Kontakt des Halteringes mit dem Wafer nicht zu einer Beschädigung des Wafers führen kann, da der Wafer nur mit den weicheren Kunststoffmaterialien in Berührung kommt.

Eine alternative Lösung hierzu ist es, wenn der Haltering einen im Kunststoffmaterial eingegossenen Metallring umfasst, welcher konzentrisch im Haltering angeordnet ist. Hier sorgt dann der Metallring für die notwendige Steifigkeit und geometrische Integrität des Halteringes, während wiederum das umgebende Kunststoffmaterial dafür sorgt, dass der zu bearbeitende Halbleiterwafer keiner mechanischen Beschädigung ausgesetzt wird.

Bevorzugt werden die Montageelemente dann an dem Metallring gehalten sein, so dass diese, die ja der Montage des Halteringes an der Poliervorrichtung dienen, eine exakte Anlage des Halteringes an der Poliervorrichtung sicherstellen und so die geometrische Struktur des Halteringes nochmals zusätzlich sichern.

Der Metallring, der von dem Kunststoffmaterial umgeben ist, kann insbesondere an der Oberseite, d.h. an der Seite des Halteringes, die der Poliervorrichtung zugewandt ist, unbedeckt bleiben, da hier kein Kontakt mit dem Wafermaterial zu besorgen ist. Ebenso ist diese Seite des Halteringes wenig bis gar nicht den chemischen Agentien des chemisch-mechanischen Poliervorganges ausgesetzt.

Bevorzugt ist allerdings eine vollständige Ummantelung des Metallringes von dem Kunststoffmaterial, da so eine größere Palette an metallischen Materialien zur Herstellung des Metallringes zur Verfügung steht, da das metallische Material von dem Kunststoffmaterial gegenüber einem chemischen Angriff durch die bei dem chemisch-mechanischen Polieren verwendeten Agentien vollständig geschützt ist.

Die einfachste Form für den Metallring zur Verstärkung des Halteringes ist ein Metallblechring. Dieser kann insbesondere gelocht oder allgemein mit Durchbrechungen versehen sein, so dass durch das durch die Durchbrüche durchgehende Kunststoffmaterial ein Formschluss zwischen dem Kunststoffmaterial und dem Metallring erfolgt.

Da die Steifigkeit des Halteringes insbesondere in Axialrichtung von großer Bedeutung ist, wird ein Metallblechring bevorzugt, der eine im Wesentlichen zylindrische Form aufweist, d.h. in Form einer Zylinderwandung verwendet.

Alternativ können auch Ringscheiben aus Metall zum Einsatz kommen, wobei dann eine größere Dicke des Blechmaterials erforderlich sein kann.

Diese und weitere Vorteile der vorliegenden Erfindung werden im Folgenden anhand der Zeichnungen noch näher erläutert. Es zeigen im Einzelnen:
- Figuren 1A - 1D:: eine erste Ausführungsform der vorliegenden Erfindung; und
- Figuren 2A - 2D:: eine weitere Ausführungsform des erfindungsgemäßen Halteringes.

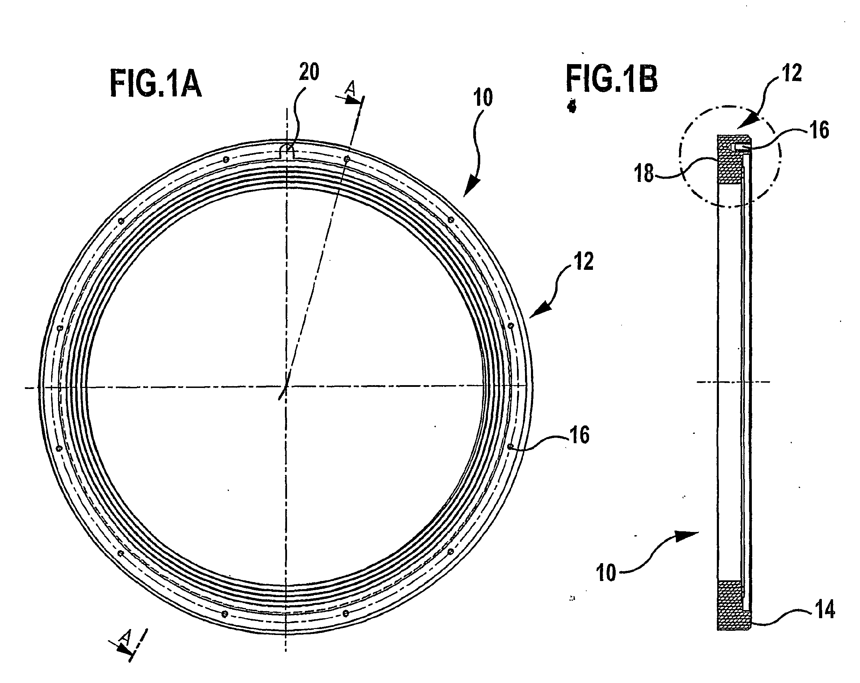

Die Figuren 1A bis 1D zeigen einen erfindungsgemäßen Haltering 10, der aus einem faserverstärkten Kunststoffmaterial hergestellt ist und der im Wesentlichen einen Rechteck-Querschnitt aufweist.

Benachbart zum Außenumfang 12 weist der Haltering 10 einen axial abstehenden umlaufenden Bund 14 auf, in den in regelmäßigen Winkelabständen Gewindebuchsen 16 eingelassen sind. Die Gewindebuchsen 16 dienen zur Befestigung des Halteringes in der chemisch-mechanischen Poliervorrichtung.

Die dem Bund 14 gegenüber liegende Seite des Halteringes 10 bildet eine Auflagefläche 18, mit der der Haltering 10 im Betrieb der Poliervorrichtung auf einer Polierfläche derselben aufliegt.

Aufgrund der kostengünstigen Fertigung des Halteringes 10 aus Kunststoff kann dieser nach einem Verschleiß der Auflagefläche 18 problemlos insgesamt entsorgt werden, und es entfällt das Problem der Wiederverwendung von Teilen des Halteringes 10.

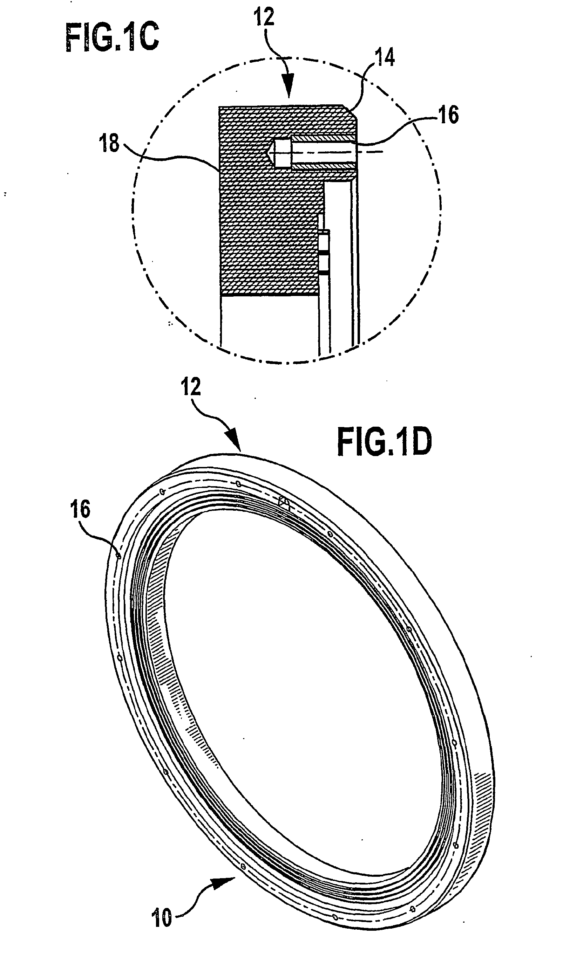

Figur 1B zeigt den erfindungsgemäßen Haltering 10 entlang der Schnittlinie A-A in Figur 1A. Figur 1C zeigt eine Detailvergrößerung aus der Schnittdarstellung der Figur 1B. In Figur 1D schließlich ist der erfindungsgemäße Haltering 10 nochmals in perspektivischer Darstellung gezeigt.

Der umlaufende Bund 14 weist auf seiner zur Poliervorrichtung hinweisenden Oberfläche eine Ausnehmung 20 auf, in welcher im montierten Zustand seitens der Poliervorrichtung ein komplementärer Vorsprung eingreift, um die winkelrichtige Orientierung des Halteringes 10 gegenüber der Poliervorrichtung zu erleichtern, so dass eine Ausrichtung der Gewindebuchsen 16 mit entsprechenden Durchbrüchen auf Seiten der Poliervorrichtung, durch die Schraubbolzen hindurchragen, automatisch erzielt werden kann.

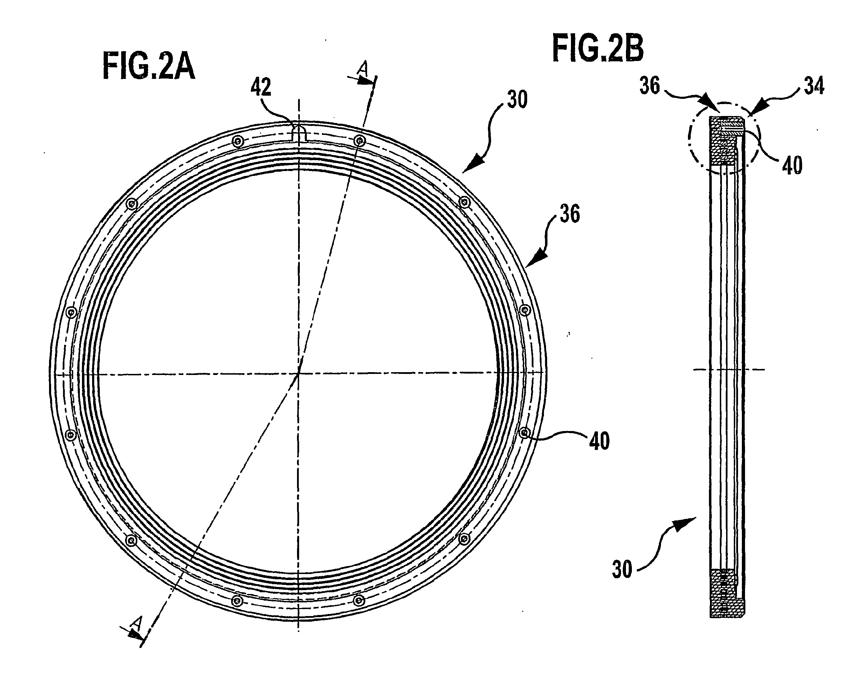

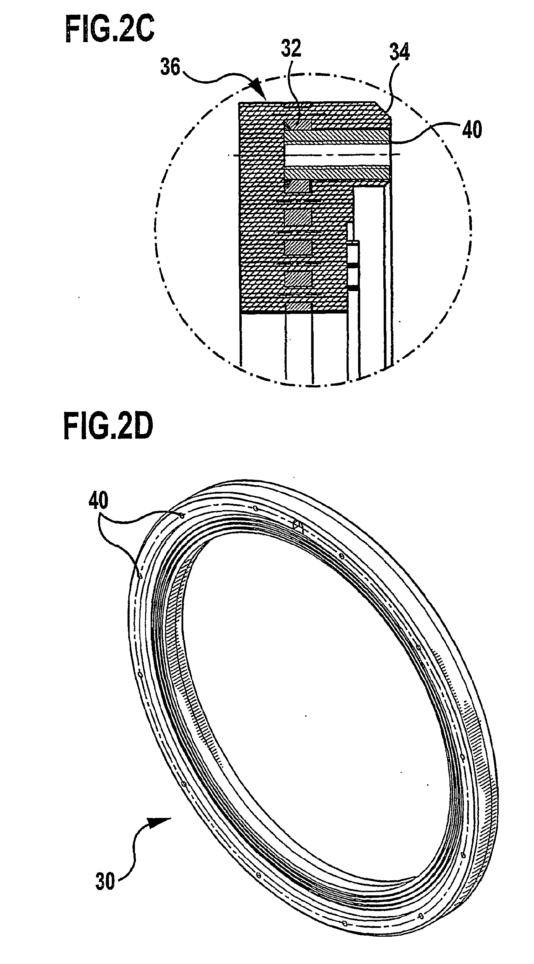

Eine weitere Ausführungsform ist in den Figuren 2A bis 2D gezeigt in Form eines Halteringes 30. Der Aufbau des Halteringes 30 unterscheidet sich von dem Aufbau des Halteringes 10 insbesondere dadurch, dass hier als Verstärkungselement für das Kunststoffmaterial in dieses ein Metallring 32 eingebettet ist. Der Metallring ist konzentrisch zu dem Haltering 30 angeordnet und aus einem Lochblechmaterial gefertigt.

Dadurch wird beim Umspritzen des Metallringes 32 das Kunststoffmaterial durch die Durchbrüche des Lochmaterials hindurchtreten und so zu einer formschlüssigen Verankerung des Metallringes 32 im Haltering 30 führen.

Der Haltering 30 weist ferner auf seiner zur Poliervorrichtung weisenden Seite einen in Axialrichtung abstehenden Bund 34 auf, welcher benachbart zur Außenumfangsfläche 36 des Halteringes 30 angeordnet ist. Im Bereich des Bundes 34 sind in regelmäßigen Winkelabständen Gewindebuchsen 40 angeordnet, mittels welchen der Haltering 30 in der Poliervorrichtung montiert werden kann.

Um die Ausrichtung der Gewindebuchsen 40 auf entsprechende Schraubbolzen auf Seiten der Poliervorrichtung zu erleichtern weist der Bund 34 eine Ausnehmung 42 auf, in welche seitens der Poliervorrichtung ein Vorsprung eingreift und so eine winkelrichtige Montage des Halteringes 30 sicherstellt.

Aufgrund der Verwendung eines Metallringes 32, der von dem Kunststoffmaterial im Wesentlichen vollständig umgeben ist, kann das Kunststoffmaterial aus einem größeren Spektrum ausgewählt werden und insbesondere auf die Erfordernisse der Abrasion bzw. Abrasionsbeständigkeit gegenüber der Polierfläche der Poliervorrichtung optimiert werden.

Die Steifigkeit des Halteringes 30 wird hier im Wesentlichen durch die Festigkeit und geometrische Integrität des Metallringes 32 (Ringscheibe) gewährleistet.

Gleichzeitig kann der Metallring 32 dazu dienen, die Gewindebuchsen 40 zu tragen, so dass der Metallring 32 mit den Gewindebuchsen 40 vorgefertigt, in ein Spritzgusswerkzeug eingelegt und danach mit Kunststoff umspritzt werden kann. Aufgrund der Tatsache, dass der Metallring 32 im Wesentlichen vollständig von dem Kunststoffmaterial des Halteringes 30 umgeben ist, kann das metallische Material, aus dem der Metallring 32 gefertigt ist, ebenfalls aus einer breiten Palette von Materialien ausgewählt werden, da dieser kaum oder gar nicht mit den chemischen Agentien, die für das chemisch-mechanische Polieren der Halbleiterwafer verwendet werden, in Berührung kommt. Korrosionsprobleme sind somit nicht zu gewärtigen.

## Patentansprüche

1. Haltering (10, 30) für eine chemisch-mechanische Poliervorrichtung für Halbleiterwafer, wobei der Haltering (10, 30) einteilig ausgebildet und aus einem verstärkten Kunststoffmaterial hergestellt ist, wobei der Haltering (10, 30) auf einer ersten Stirnseite (18) eine Auflagefläche zur Auflage des Halteringes auf einer Polieroberfiäche der Poliervorrichtung bildet und auf der in Axialrichtung der ersten Stirnseite entgegengesetzt liegenden Seite Montageelement (16, 40) umfasst, mittels welchen der Haltering in der Poliervorrichtung montierbar ist, **dadurch gekennzeichnet, dass** das Kunststoffmaterial benachbart zu seiner ersten Stirnseite (18) einen geringeren Gehalt an Verstärkungsstoffen aufweist als an seiner die Montageelemente (16, 40) umfassenden Seite und dass der Haltering optional einen im Kunststoffmaterial eingegossenen Metallring (32) umfasst, welcher konzentrisch im Haltering (10, 30) angeordnet ist.

2. Haltering nach Anspruch 1, **dadurch gekennzeichnet, dass** der Haltering aus mindestens zwei Schichten oder Komponenten sandwichartig aufgebaut ist.

3. Haltering nach Anspruch 1 oder 2, **dadurch gekennzeichnet, dass** das Kunststoffmaterial ein Thermoplast, ein Duroplast, ein Elastomer und/oder eine Kunststoffmischung umfasst.

4. Haltering nach einem der Ansprüche 1 bis 3, **dadurch gekennzeichnet, dass** das Kunststoffmaterial ein faserverstärktes Kunststoffmaterial ist.

5. Haltering nach einem der voranstehenden Ansprüche, **dadurch gekennzeichnet, dass** dem Kunststoffmaterial reib- und/oder verschleißmindernde Zusatzstoffe beigemischt sind.

6. Haltering nach einem der Ansprüche 1 bis 5, **dadurch gekennzeichnet, dass** die Montageelemente an dem Metallring gehalten sind.

7. Haltering nach einem der Ansprüche 1 bis 6, **dadurch gekennzeichnet, dass** der Metallring von dem Kunststoffmaterial vollständig ummantelt ist.

8. Haltering nach einem der Ansprüche 1 bis 7, **dadurch gekennzeichnet, dass** der Metallring ein Metallblechring ist.

9. Haltering nach Anspruch 8, **dadurch gekennzeichnet, dass** der Metallblechring ein gelochter Metallblechring ist.

10. Haltering nach Anspruch 8 oder 9, **dadurch gekennzeichnet, dass** der Metallblechring eine im Wesentlichen zylindrische Form aufweist.

11. Haltering nach Anspruch 9 oder 10, **dadurch gekennzeichnet, dass** der Metallblechring die Form einer Ringscheibe aufweist.

## Claims

1. Retaining ring (10, 30) for a chemical-mechanical polishing apparatus for semiconductor wafers, wherein the retaining ring (10, 30) is of integral design and is made of a reinforced plastics material, wherein the retaining ring (10, 30) forms on a first front side (18) a supporting face for supporting the retaining ring on a polishing surface of the polishing apparatus and comprises on the opposite side to the first front side in the axial direction mounting elements (16, 40) by means of which the retaining ring can be mounted in the polishing apparatus, **characterised in that** the plastics material has a lower content of reinforcement substances adjacent to its first front side (18) than at its side comprising the mounting elements (16, 40), and that the retaining ring optionally comprises a metal ring (32) which is integrally cast in the plastics material and arranged concentrically in the retaining ring (10, 30),

2. Retaining ring according to Claim 1, **characterised in that** the retaining ring is composed like a sandwich of at least two layers or components.

3. Retaining ring according to Claim 1 or 2, **characterised in that** the plastics material comprises a thermoplastic, a thermosetting plastic, an elastomer and/or a plastics mixture.

4. Retaining ring according to any one of Claims 1 to 3, **characterised in that** the plastics material is a fibre-reinforced plastics material.

5. Retaining ring according to any one of the preceding Claims, **characterised in that** friction- and/or wear-reducing additives are admixed with the plastics material.

6. Retaining ring according to any one of Claims 1 to 5, **characterised in that** the mounting elements are retained on the metal ring.

7. Retaining ring according to any one of Claims 1 to 6, **characterised in that** the metal ring is completely encased by the plastics material.

8. Retaining ring according to any one of Claims 1 to 7, **characterised in that** the metal ring is a sheet metal ring.

9. Retaining ring according to Claim 8, **characterised in that** the sheet metal ring is a perforated sheet metal ring.

10. Retaining ring according to Claim 8 or 9, **characterised in that** the sheet metal ring has a substantially cylindrical shape.

11. Retaining ring according to Claim 9 or 10, **characterised in that** the sheet metal ring has the shape of an annular disc.

## Revendications

1. Bague de retenue (10, 30) pour dispositif de polissage chimique et mécanique de plaquette de semiconducteur, la bague de retenue (10, 30) étant conformée d'une seule pièce et étant fabriquée à partir d'une matière plastique renforcée, la bague de retenue (10, 30) formant sur un premier côté frontal (18) une surface de support destinée au support de la bague de retenue sur une surface de polissage du dispositif de polissage et comportant, sur le côté opposé au premier côté frontal dans la direction axiale, des éléments de montage (16, 40) au moyen desquels la bague de retenue peut être montée dans le dispositif de polissage, **caractérisée en ce que** la matière plastique a, au voisinage de son premier côté frontal (18), une teneur en matières de renforcement qui est inférieure celle qu'elle a du côté comportant les éléments de montage (16, 40), et **en ce que** la bague de retenue comporte en option une bague métallique (32) qui est incorporée dans la matière plastique et qui est disposée concentriquement dans la bague de retenue (10, 30).

2. Bague de retenue selon la revendication 1, **caractérisée en ce que** la bague de retenue a une structure en sandwich constituée d'au moins deux couches ou composants.

3. Bague de retenue selon la revendication 1 ou 2, **caractérisée en ce que** la matière plastique comporte une matière thermoplastique, une matière duroplastique, un élastomère et/ou un mélange de matières plastiques.

4. Bague de retenue selon l'une des revendications 1 à 3, **caractérisée en ce que** la matière plastique est une matière plastique renforcée par des fibres.

5. Bague de retenue selon l'une des revendications précédentes, **caractérisée en ce que** des additifs réducteur de friction et/ou d'usure sont mélangés à la matière plastique.

6. Bague de retenue selon l'une des revendications 1 à 5, **caractérisée en ce que** les éléments de montage sont supportés par la bague métallique.

7. Bague de retenue selon l'une des revendications 1 à 6, **caractérisée en ce que** la bague métallique est enveloppée en totalité par la matière plastique.

8. Bague de retenue selon l'une des revendications 1 à 7, **caractérisée en ce que** la bague métallique est une bague de tôle métallique.

9. Bague de retenue selon la revendication 8, **caractérisée en ce que** la bague de tôle métallique est une bague de tôle métallique perforée.

10. Bague de retenue selon la revendication 8 ou 9, **caractérisée en ce que** la bague de tôle métallique a une forme sensiblement cylindrique.

11. Bague de retenue selon la revendication 9 ou 10, **caractérisée en ce que** la bague de tôle métallique a la forme d'un disque annulaire.
